# FASCICULE DE BREVET EUROPEEN

(11) **EP 3 914 058 B1**
(45) Date de publication et mention de la délivrance du brevet: **12.06.2024**
(21) Numéro de dépôt: 21174684.7
(22) Date de dépôt: 19.05.2021
(51) Int. Cl.: H05K 7/14

(54) **ENSEMBLE AMÉLIORÉ POUR INSÉRER/EXTRAIRE UN MODULE À L'INTÉRIEUR/HORS D'UN SUPPORT D'ACCUEIL**
VERBESSERTE ANORDNUNG ZUM EINSETZEN/HERAUSNEHMEN EINES MODULS IN EINE/AUS EINER DOCKINGSTATION
IMPROVED ASSEMBLY FOR INSERTING/EXTRACTING A MODULE INTO/FROM OF A DOCKING SUPPORT

(30) Priorité: 19.05.2020 FR 2005002
(43) Date de publication de la demande: 24.11.2021
(73) Titulaire: THALES, 92400 Courbevoie (FR)
(72) Inventeur: VITET, Sylvain, 33700 Merignac (FR); GAUTIER, Christian, 33700 Merignac (FR); CARILLON, Guillaume, 33700 Merignac (FR)
(74) Mandataire: Lavoix

(56) Documents cités:
- WO-A1-03/092346
- DE-U1- 8 911 273
- FR-A1- 2 979 794
- US-A- 3 476 258
- US-A1- 2002 090 851
- US-B1- 10 136 547

## Description

L'invention a pour domaine celui des modules fonctionnels enfichables dans une structure d'accueil. Plus particulièrement, l'invention a pour domaine celui des cartes électroniques enfichables dans une baie électronique.

Le document US 10 136 547 B1 propose un ensemble pour insérer/extraire une carte électronique à l'intérieur/hors d'une baie électronique selon une direction de déplacement, ledit ensemble étant constitué d'une pièce fixe et d'une poignée coopérant avec la pièce fixe, la poignée comportant un corps, qui est muni, selon une direction longitudinale, d'un côté, d'un manche et, de l'autre côté, d'un dispositif d'engrènement, et qui comporte un axe s'étendant selon une direction transversale, la pièce fixe étant solidaire de la carte électronique et comportant une gorge de guidage de l'axe de la poignée selon un trajet reposant dans un plan perpendiculaire à la direction transversale.

Pour la manipulation d'une carte électronique, la face avant de celle-ci est munie de deux poignées, qui sont montées au voisinage des extrémités longitudinales de la face avant de la carte. Ces poignées permettent la préhension de la carte par un opérateur, afin de l'insérer à l'intérieur ou de l'extraire hors d'un compartiment de réception prévu dans la baie électronique.

Cependant, l'opérateur doit exercer un certain effort pour coupler/découpler les connecteurs équipant la face arrière de la carte, des connecteurs antagonistes équipant le fond du compartiment de réception.

Or, dans certains cas, l'effort que doit exercer l'opérateur lors de l'insertion et de l'extraction peut atteindre plusieurs dizaines de kilogrammes. C'est par exemple le cas pour les cartes électroniques 6U présentant une connectique VPX, qui nécessitent un effort de l'ordre de 40 kilogrammes afin de coupler ou découpler les connecteurs de la carte et les connecteurs antagonistes de la baie.

Les poignées, dont sont actuellement équipées les cartes électroniques, ne sont pas adaptées à un tel emploi, en particulier au transfert d'un effort important.

Elles se dégradent par conséquent rapidement. Elles peuvent alors détériorer la carte électronique au niveau de leurs points d'implantation sur la face avant de la carte. De plus, si l'effort n'est pas correctement transmis selon la direction de déplacement de la carte, l'interface entre cette dernière et la baie risque également d'être détériorée.

Les poignées peuvent se casser, au risque de blesser l'opérateur.

Par ailleurs, les poignées actuelles ne présentent pas une ergonomie permettant à l'opérateur d'appliquer un effort élevé.

Le but de la présente invention est par conséquent de résoudre ces problèmes.

Pour cela l'invention a pour objet un ensemble pour insérer/extraire une carte électronique à l'intérieur/hors d'une baie électronique selon les revendications annexées.

L'invention et ses avantages seront mieux compris à la lecture de la description détaillée qui va suivre d'un mode de réalisation particulier, donné uniquement à titre d'exemple non limitatif, cette description étant faite en se référant aux dessins annexés sur lesquels :
- la figure 1 est une vue en perspective d'une paire d'ensembles selon l'invention, équipant une carte électronique logée dans une baie électronique, dont seuls les montants avant sont représentés pour des raisons de clarté ;
- la figure 2 est une vue de face de la pièce fixe d'un ensemble selon l'invention ;
- la figure 3 est une coupe selon un plan perpendiculaire à une direction transversale d'un ensemble selon l'invention lors de l'insertion de la carte dans la baie ; et
- la figure 4 est une coupe de l'ensemble de la figure 3 lors de l'extraction de la carte hors de la baie.

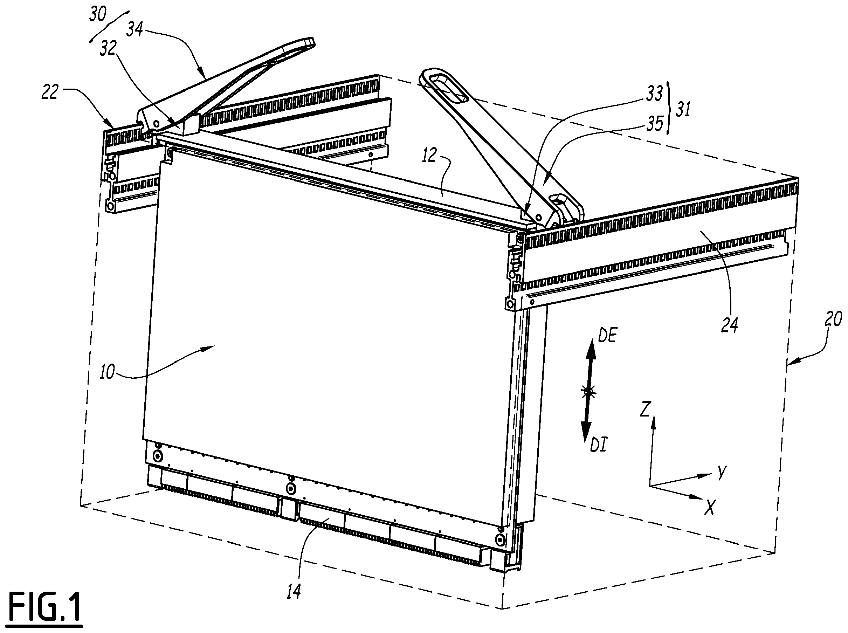

Sur la figure 1, est représentée une carte électronique 10 insérée dans une baie électronique 20, dont seuls les montants latéraux avant, 22 et 24, sont représentés pour des raisons de clarté.

Un repère orthonormal X-Y-Z est associé à la baie 20 de sorte que l'axe X corresponde à la direction longitudinale de la face avant 12 de la carte électronique 10 une fois que celle-ci est en position dans un compartiment de réception ménagé dans la baie 20 ; la direction Z correspond à la direction de déplacement de la carte électronique 10 par rapport à la baie 20, soit selon une direction d'insertion DI soit selon une direction d'extraction DE. Enfin, la direction Y est une direction transversale au plan X-Z.

Les montants 22 et 24 de la baie 20 sont des profilés selon la direction transversale Y.

La carte électronique 10 définit un plan parallèle au plan XZ, lorsqu'elle est en position dans le compartiment de réception.

La carte électronique 10 comporte une face avant 12. Elle comporte, sur l'arête opposée, une pluralité de connecteurs 14, qui sont destinés à être mécaniquement et électriquement couplés à des connecteurs antagonistes prévus sur la paroi de fond de la baie électronique 20.

Selon l'invention, est utilisé pour insérer et extraire la carte électronique 10 de la baie électronique 20, au moins un ensemble constitué d'une pièce fixe et d'une poignée.

La poignée selon l'invention amovible.

Sur la figure 1 une paire d'ensembles est représentée.

Plus précisément, un premier ensemble 30, constitué d'une pièce fixe 32 et d'une poignée amovible 34, est prévu à l'une des extrémités longitudinales de la face avant 12 de la carte 10 ; tandis qu'un second ensemble 31, composé d'une pièce fixe 33 et d'une poignée amovible 35, est prévu à l'autre extrémité longitudinale de la face avant 12 de la carte 10.

Dans la suite de la présente description, sera plus particulièrement présenté l'ensemble 30 et par conséquent la pièce fixe 32 et la poignée amovible 34. Mais une description similaire pourrait être faite pour l'ensemble 31.

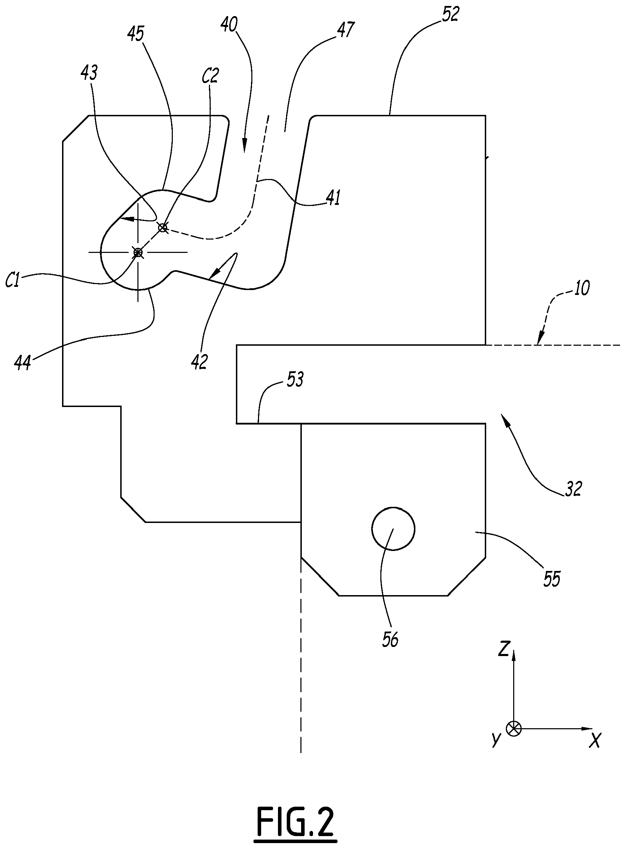

La pièce fixe 32 est représentée avec plus de détails à la figure 2.

La pièce fixe 32 est destinée à être solidaire de la face avant 12 de la carte électronique 10. Par exemple, la pièce fixe 32 comporte une échancrure 53 permettant de recevoir le bord de la face avant 12 de la carte 10. La pièce 32 comporte également un ergot 55, muni d'un trou traversant 56 pour le passage de moyens de fixation de la pièce fixe 32 sur la carte 10. Ces moyens sont par exemple un ensemble vis/écrou.

La pièce fixe 32 est de forme sensiblement parallélépipédique.

Elle comporte une gorge 40 de guidage d'un axe 65 de la poignée 34, qui sera décrite ci-après.

La gorge 40 définit un trajet 41 dans un plan parallèle au plan X-Z de la carte 10.

La gorge 40 est délimitée par une première surface 42. Cette première surface 42 est transversale et est la surface de la gorge la plus proche de la carte 10.

La gorge 40 est délimitée par une seconde surface 43. Il s'agit d'une surface transversale située plus à l'écart de la carte 10 que la première surface 42. La seconde surface 43 est en vis-à-vis de la première surface 42.

La première surface 42 est conformée pour présenter un cran définissant un premier logement 44. Le premier logement 44 est en forme d'arc de cercle de centre C1 et de rayon sensiblement égal au rayon de l'axe 65 de la poignée 34.

La seconde surface 43 comporte un cran délimitant un second logement 45. Le second logement 45 est en forme d'arc de cercle de centre C2 et de rayon sensiblement égal au rayon de l'axe 65 de la poignée 34.

Les centres C1 et C2 sont situés sur la trajet 41 que défini la gorge 40 de guidage, en des points différents de ce trajet. Dit autrement, les centres C1 et C2 ne sont pas confondus l'un avec l'autre.

La gorge 40 selon l'invention est ouverte sur la face avant 52 de la pièce fixe 32. La gorge 40 présente ainsi une ouverture 47 permettant l'introduction ou l'extraction de l'axe 65 de la poignée 34 lors de l'utilisation de cette dernière ou à la suite de l'utilisation de cette dernière pour déplacer la carte 10.

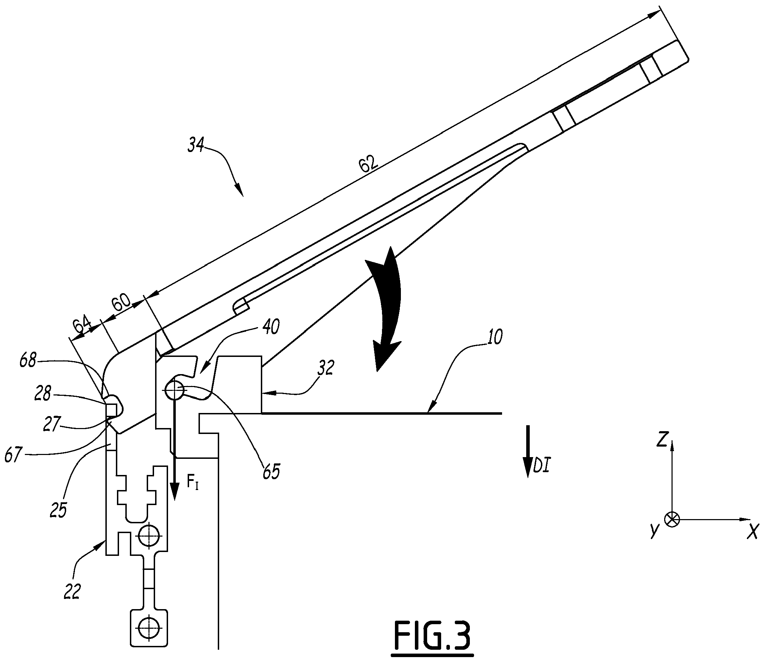

Comme représenté sur la figure 3, la poignée amovible 34 comporte un corps 60 qui est muni, selon une direction longitudinale, d'une part d'un manche 62 et d'autre part de moyens d'engrènement 64.

Le corps 60 est muni d'un axe 65 disposé transversalement.

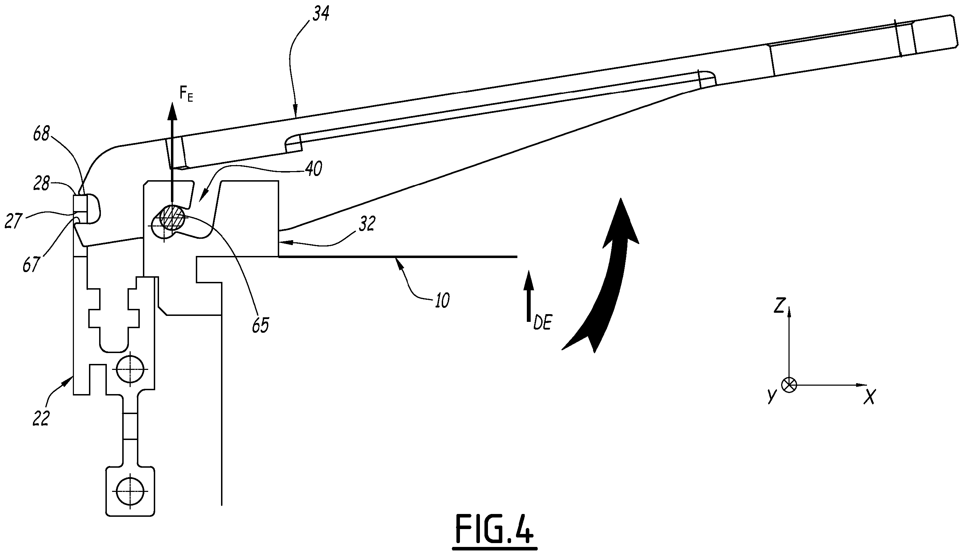

Lorsque la poignée amovible 34 est couplée à la pièce fixe 32 pour permettre l'insertion ou l'extraction de la carte électronique 10 (situation représentée sur les figures 3 et 4), l'axe 65 est parallèle à l'axe transversal Y, tandis que le corps 60, le manche 62 et le dispositif d'entraînement 64 sont disposés dans un plan parallèle au plan X-Z de la carte 10.

Dans le mode de réalisation actuellement envisagé, le dispositif d'engrènement 64 est constitué d'une première dent 67 et d'une seconde dent 68, qui sont disposées en face à face l'une de l'autre, à une distance prédéfinie.

Le montant 22 de la baie présente un orifice 25 traversant. De ce fait, le montant 22 est muni d'un le bord avant présentant une première surface transversale 27 et une seconde surface transversale 28.

La première surface transversale 27 constitue une surface d'appui pour la première dent 67 de la poignée 34, tandis que la seconde face transversale 28 constitue une surface d'appui pour la seconde dent 68 de la poignée 34.

Pour insérer la carte 10 en utilisant l'ensemble selon l'invention, l'opérateur présente d'abord l'axe transversal 65 en face de l'ouverture 47 de la gorge 40, puis l'introduit dans la gorge 40.

L'opérateur vient ensuite associer le dispositif d'engrènement 64 sur le montant 22 de la baie 20 de manière à établir une liaison de type pivot. Pour cela, l'opérateur est aidé par le guidage de l'axe 65 de la poignée 34 le long de la gorge 40.

Enfin, l'opérateur termine le mouvement de mise en place de la poignée 34, en plaçant l'axe transversal 65 dans le premier logement 44 de la gorge 40.

Dans cette configuration, la première dent 67 est en appui contre la première surface 27 de la baie 20.

L'opérateur peut alors appliquer un effort d'insertion sur le manche 62, dirigé selon la flèche indiquée sur la figure 3, de manière à générer, au niveau du point de contact entre l'axe 65 et la pièce fixe 32, une force d'insertion FI sur la pièce fixe 32. La force d'insertion est dirigée selon la direction d'insertion DI.

Sous l'effet de cette force, la carte 10 est repoussée au fond du compartiment de réception prévu dans la baie électronique 20 et les connecteurs 14 de la face arrière de la carte 10 sont engagés dans les contacteurs antagonistes de la baie 20.

Finalement, la carte 10 est en position dans la baie 20 et l'opérateur peut avantageusement démonter la poignée 34 en sortant l'axe 65 de la gorge 40.

Le rapport de la distance entre le point de pivotement de la poignée 34 et le point de la poignée où l'opérateur applique un effort et la distance entre le point de pivotement de la poignée 34 et l'axe 65 crée un bras de levier de nature à amplifier la force d'insertion FI par rapport à l'effort appliqué par l'opérateur. Celui-ci n'a donc qu'un effort limité à fournir pour appliquer une force d'insertion élevée de nature à vaincre les frottements lors du couplage des connecteurs et connecteurs antagonistes.

En se référant maintenant à la figure4, pour l'extraction de la carte électronique 10 hors de la baie 20, l'opérateur présente d'abord l'axe transversal 65 de la poignée 34 en face de l'ouverture 47 de la gorge 40, puis l'introduit dans la gorge 40.

L'opérateur vient ensuite associer le dispositif d'engrènement 64 sur le montant 22 de la baie 20 de manière à établir une liaison de type pivot. Pour cela, l'opérateur est aidé par le guidage de l'axe 65 de la poignée 34 le long de la gorge 40.

Enfin, l'opérateur termine le mouvement de mise en place de la poignée 34, en plaçant l'axe transversal 65 dans le second logement 45 de la gorge 40.

Dans cette configuration, c'est la seconde dent 68 qui vient prendre appui sur la seconde surface d'appui 28 du montant 22 de la baie électronique 10.

L'opérateur peut alors appliquer un effort d'extraction, selon la flèche représentée en traits épais sur la figure 4, de manière à générer, au niveau du point de contact entre l'axe 65 et la pièce fixe 32, une force d'extraction FE, qui est parallèle à la direction d'extraction DE.

Une fois encore, la poignée 34 permet, par un effet de levier, d'amplifier l'effort produit par l'opérateur pour générer une force d'extraction de nature à permettre de vaincre la friction mécanique entre les connecteurs dont est munie la carte et les connecteurs antagonistes dont est muni le fond de la baie électronique.

Sous l'effet de cette force, la carte 10 est désolidarisée du compartiment de réception et extraite de la baie 20.

Finalement, uns fois la carte 10 déposée, l'opérateur peut démonter la poignée 34 en sortant l'axe 65 de la gorge 40.

Avantageusement, la pièce fixe 32 peut être équipé d'un plot de connexion venant s'engager dans une rainure de forme adaptée dont est muni le montant 22 de la baie. Ceci permet de verrouilles en position la carte électronique 10 dans la baie 20.

En variante d'autres moyens d'engrènement pourraient être mis en oeuvre. Par exemple, le montant de la baie pourrait être muni d'une encoche et le dispositif d'engrènement constitué d'une saillie de forme complémentaire de cette encoche. Lors de l'utilisation de la poignée, la saillie est placée à l'intérieur de l'encoche pour constituer la liaison pivot.

L'homme du métier constatera que l'ensemble selon l'invention présente une cinématique adaptée à l'insertion et à l'extraction d'une carte dans une baie.

En particulier, comme indiqué précédemment, les centres C1 et C2 sont situés en des points différents du trajet que défini la gorge de guidage. Cette caractéristique permet d'adapter la position de la poignée 34 à la cinématique recherchée : Le centre C1 permet d'optimiser le contact entre la dent 67 de la poignée 34 et la surface 27 du montant 22 lors d'une opération d'insertion ; Le centre C2 permet d'optimiser le contact entre la dent 68 de la poignée 34 et la surface 28 du montant 22 lors d'une opération d'extraction.

Cet ensemble évite tout risque d'endommager soit la face avant de la carte, soit le montant de la baie électronique.

Il permet d'amplifier l'effort que doit appliquer l'opérateur et améliore par conséquent le confort d'utilisation.

Le transfert de la force d'insertion ou de la force d'extraction de la poignée vers la pièce fixe et de la pièce fixe vers la carte s'effectue de manière à garantir que cette force soit dirigée parallèlement à la direction nominale de déplacement de la carte dans la baie. Cela empêche l'application de contraintes longitudinales ou transversales risquant de dégrader l'interface entre la carte et la baie électronique, que ce soit au niveau des montants de baie, au niveau des connecteurs, ou encore au niveau des rails de guidage de la carte, qui définissent le compartiment de réception de cette dernière.

Le mode de réalisation présenté ci-dessus en détail et relatif à une carte électronique en tant qu'exemple de module fonctionnel et d'une baie électronique en tant que structure d'accueil. Cependant, la présente invention trouve des applications dans d'autres domaines techniques que celui de l'électronique. Ainsi, l'invention pourrait s'appliquer dans le domaine hydraulique, le domaine pneumatique ou encore le domaine électrique.

## Revendications

1. Ensemble (30) pour insérer/extraire une carte électronique (10) à l'intérieur/hors d'une baie électronique (20) selon une direction de déplacement,
ledit ensemble étant constitué d'une pièce fixe (32) et d'une poignée (34) coopérant avec la pièce fixe,
la poignée (34) comportant un corps (60), qui est muni, selon une direction longitudinale, d'un côté, d'un manche (62) et, de l'autre côté, d'un dispositif d'engrènement (64), et qui comporte un axe (65) s'étendant selon une direction transversale,
la pièce fixe (32) étant solidaire de la carte électronique (10) et comportant une gorge (40) de guidage de l'axe (65) de la poignée (34) selon un trajet (41) reposant dans un plan perpendiculaire à la direction transversale,
l'ensemble étant **caractérisé en ce que** :
une première surface transversale (42) de la gorge est conformée pour présenter un premier cran formant un premier logement (44) de réception de l'axe de la poignée et, une seconde surface transversale (43) de la gorge, en vis-à-vis de la première surface transversale, est conformée pour présenter un second cran formant un second logement (45) de réception de l'axe de la poignée,
de sorte que, pour insérer la carte électronique, l'axe (65) est placé dans le premier logement (44) et le dispositif d'engrènement (64) est couplé à un montant (22) de la baie électronique de manière à ce que, lorsqu'un opérateur applique un effort d'insertion sur le manche de la poignée, une force d'insertion (FI) est appliquée sur la carte électronique pour la déplacer selon une direction d'insertion (DI) parallèle à la direction de déplacement ; et, pour extraire la carte électronique, l'axe (65) est placé dans le second logement (45) et le moyen d'engrènement (64) est couplé au montant (22) de la baie électronique de manière à ce que, lorsqu'un opérateur applique un effort d'extraction sur le manche de la poignée, opposé à l'effort d'insertion, une force d'extraction (FE) soit appliquée sur la carte électronique pour la déplacer selon une direction d'extraction (DE), opposée à la direction d'insertion,
la poignée (34) étant amovible, la gorge (40) comportant une ouverture permettant d'introduire, respectivement de sortir, l'axe (65) de la poignée dans la gorge, respectivement hors de la gorge, pour coupler ou découpler la poignée (34) de la pièce fixe (32).

2. Ensemble selon la revendication 1, dans lequel le montant (22) de la baie électronique (20) présente des première et seconde surfaces d'appui (27, 28), dont les normales sont sensiblement parallèles à la direction de déplacement, et dans lequel le dispositif d'engrènement (64) présente des première et seconde dents (67, 68) propres à venir en appui respectivement des première et seconde surfaces d'appui pour former un pivot entre la poignée (34) et la baie électronique (20).

## Patentansprüche

1. Anordnung (30) zum Einsetzen/Entfernen einer elektronischen Karte (10) in/aus einem Elektronikschacht (20) entlang einer Bewegungsrichtung,
wobei die Anordnung aus einem festen Teil (32) und einem Griff (34) besteht, der mit dem festen Teil zusammenwirkt,
wobei der Griff (34) einen Körper (60) aufweist, der in einer Längsrichtung auf einer Seite mit einem Griff (62) und auf der anderen Seite mit einer Eingriffsvorrichtung (64) versehen ist, und der eine Achse (65) aufweist, die sich in einer Querrichtung erstreckt,
wobei das feste Teil (32) fest mit der elektronischen Karte (10) verbunden ist und eine Nut (40) zur Führung der Achse (65) des Griffs (34) entlang einer Bahn (41) aufweist, die in einer Ebene senkrecht zur Querrichtung liegt,
wobei die Anordnung **dadurch gekennzeichnet ist, dass**:
eine erste Querfläche (42) der Nut so geformt ist, dass sie eine erste Kerbe aufweist, die eine erste Aufnahme (44) für die Achse des Griffs bildet und eine zweite Querfläche (43) der Nut, die der ersten Querfläche gegenüberliegt, so geformt ist, dass sie eine zweite Kerbe aufweist, die eine zweite Aufnahme (45) für die Achse des Griffs bildet,
So dass zum Einsetzen der elektronischen Karte die Achse (65) in der ersten Aufnahme (44) platziert und die Eingriffsvorrichtung (64) mit der Säule (22) des Elektronikschachts so gekoppelt wird, dass wenn ein Bediener eine Einführungskraft auf den Schaft des Griffs ausübt, eine Einführungskraft (FI) auf die elektronische Karte ausgeübt wird, um sie in einer Einführrichtung (DI) parallel zur Bewegungsrichtung zu bewegen; und, um die elektronische Karte zu entfernen, wird die Achse (65) in der zweiten Aufnahme (45) platziert und das Eingriffsmittel (64) ist mit der Säule (22) des Elektronikschachts so gekoppelt, dass wenn ein Bediener eine der Einführungskraft entgegengesetzte Auszugsanstrengung auf den Schaft des Griffs ausübt, eine Auszugskraft (FE) auf die elektronische Karte ausgeübt wird, um sie in einer Auszugsrichtung (DE) zu bewegen, die der Einführrichtung entgegengesetzt ist,
wobei der Griff (34) abnehmbar ist und die Nut (40) eine Öffnung aufweist, die es ermöglicht, die Achse (65) des Griffs in die Nut einzuführen bzw. aus der Nut herauszuführen, um den Griff (34) mit dem festen Teil (32) zu koppeln oder zu entkoppeln.

2. Anordnung nach Anspruch 1, bei der die Säule (22) des Elektronikschachts (20) eine erste und eine zweite Auflagefläche (27, 28) aufweist, deren Normalen im Wesentlichen parallel zur Bewegungsrichtung sind, und wobei die Eingriffsvorrichtung (64) erste und zweite Zähne (67, 68) aufweist, die geeignet sind, jeweils an der ersten und zweiten Stützfläche zur Anlage zu kommen, um ein Drehgelenk zwischen dem Griff (34) und dem Elektronikschacht (20) zu bilden.

## Claims

1. An assembly (30) for inserting/extracting an electronic card (10) inside/outside an electronic rack (20) in a direction of movement,
said assembly consisting of a fixed part (32) and a handle (34) cooperating with the fixed part,
the handle (34) comprising a body (60), which is provided, in a longitudinal direction, on one side, with a handle (62) and, on the other side, with an engagement device (64), and which comprises an axis (65) extending in a transverse direction,
the fixed part (32) being integral with the electronic board (10) and comprising a groove (40) for guiding the shaft (65) of the handle (34) along a path (41) lying in a plane perpendicular to the transverse direction,
the assembly being **characterised in that**:
a first transverse surface (42) of the groove is shaped to present a first notch forming a first housing (44) for receiving the handle shaft and, a second transverse surface (43) of the groove, opposite the first transverse surface, is shaped so as to have a second notch forming a second housing (45) for receiving the shaft of the handle,
so that, in order to insert the electronic card, the pin (65) is placed in the first housing (44) and the engagement device (64) is coupled to an upright (22) of the electronic rack in such a way that, when an operator applies an insertion force to the handle, an insertion force (IF) is applied to the electronic card in order to move it in an insertion direction (ID) parallel to the direction of movement; and, to extract the electronic card, the pin (65) is placed in the second housing (45) and the engagement means (64) is coupled to the upright (22) of the electronic rack so that, when an operator applies an extraction force to the handle, opposite the insertion force, an extraction force (EF) is applied to the electronic card to move it in an extraction direction (ED), opposite to the insertion direction,
the handle (34) being removable, the groove (40) comprising an opening enabling the shaft (65) of the handle to be introduced into the groove, or withdrawn from the groove, in order to couple or uncouple the handle (34) from the fixed part (32).

2. An assembly according to claim 1, in which the upright (22) of the electronic rack (20) has first and second bearing surfaces (27, 28), the normals of which are substantially parallel to the movement direction, and in which the engagement device (64) has first and second teeth (67, 68) suitable for bearing against the first and second bearing surfaces respectively to form a pivot between the handle (34) and the electronic rack (20).
